# EUROPEAN PATENT APPLICATION

(11) **EP 2 618 482 A1**
(43) Date of publication of application: **24.07.2013**
(21) Application number: 11783067.9
(22) Date of filing: 02.06.2011
(51) Int. Cl.: H03F 3/20, H01L 23/66, H01L 23/00, H01L 25/065, H03F 1/02

(54) **POWER AMPLIFIER, ASYMMETRIC DOHERTY POWER AMPLIFIER DEVICE AND BASE STATION**

(30) Priority: 14.09.2010 CN 201010281316
(71) Applicant: Huawei Technologies Co., Ltd., Shenzhen, Guangdong 518129 (CN)
(72) Inventor: YIN, Weimin, Shenzhen Guangdong 518129 (CN); SUN, Jie, Shenzhen Guangdong 518129 (CN); SHI, Junqin, Shenzhen Guangdong 518129 (CN); ZHANG, Xikun, Shenzhen Guangdong 518129 (CN); JIAO, Wei, Shenzhen Guangdong 518129 (CN)
(74) Representative: Epping - Hermann - Fischer
(86) International application number: PCT/CN2011/075180
(87) International publication number: WO 2011/144150

(57) **Abstract**

The embodiments of the present invention have disclosed a power amplifier, an asymmetric Doherty power amplifier device and a base station. In the embodiments of the present invention, different radio frequency power amplifier channels are integrated within a component to form a power amplifier, thus reducing the discreteness between the different radio frequency power amplifier channels in such a way that a test and a selection are performed during production, and avoiding the occurrence of a situation that performance can not be controlled as the component discreteness between the different radio frequency power amplifier channels can be only found during application in the prior art. Since the power amplifier is a single component, a lower discreteness can be guaranteed during application, which is helpful to improve the performance of the ADPA circuit.

## Description

The present application claims the priority of Chinese Patent Application No.201010281316.4, filed in Chinese Patent Office on September 14, 2010, and entitled "Power Amplifier, Asymmetric Doherty Power Amplifier Device and Base Station", the entire contents of which are herein incorporated by reference.

### TECHNICAL FIELD

The present invention relates to the field of electronic information, and particularly, to a power amplifier, an asymmetric Doherty power amplifier (ADPA, asymmetric Doherty power amplifier) device and a base station.

### BACKGROUND

Among the growing mobile communication base station products, a radio frequency power amplifier is constantly developing to have a performance of higher efficiency, larger bandwidth, better linear and smaller area. With a commercial application of a high peak-to-average ratio signal, such as, global system for mobile communications (GSM, Global System for Mobile Communications) multi-carrier, wideband code division multiple access (WCDMA, Wideband Code Division Multiple Access) multi-carrier, long term evolution (LTE, Long Term Evolution) system, and so on, a radio frequency power amplifier needs to work in a scene with more back-off, in order to ensure that the high peak-to-average ratio signal is not compressed or is less compressed to avoid signal distortion. The back-off means that output power of the radio frequency power amplifier is smaller than saturation power of the radio frequency power amplifier, whose value is equal to the difference between the saturation power and the output power. The efficiency of the radio frequency power amplifier will have certain loss due to too much back-off.

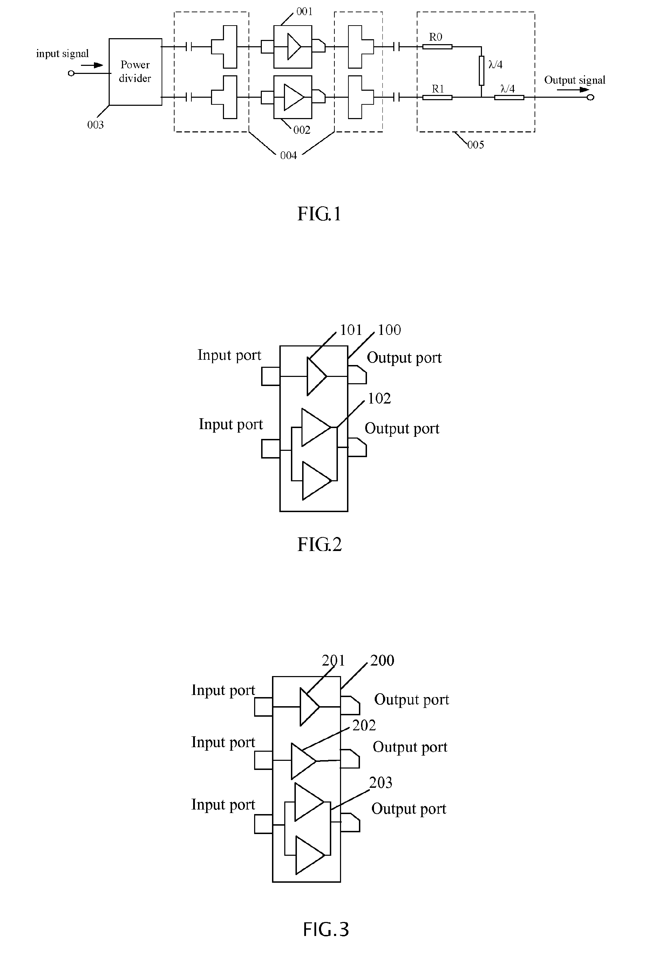

In order to ensure sufficient back-off and meet a requirement of high efficiency, an asymmetric Doherty power amplifier (ADPA, Asymmetric Doherty Power Amplifier) technology is adopted, namely to adopt multiple different components to form an ADPA circuit (called ADPA device below). For example, as shown in Fig. 1, the ADPA circuit includes a main radio frequency power amplifier 001, a peak radio frequency power amplifier 002, a power divider 003, an impedance conversion circuit 004 and a Doherty combining circuit 005. After split through the power divider 003, an input signal enters the radio frequency power amplifiers through an input impedance conversion circuit in the impedance conversion circuit 004. The main radio frequency power amplifier 001 and the peak radio frequency power amplifier 002 both belong to a single-channel component. The main radio frequency power amplifier 001 and the peak radio frequency power amplifier 002 are connected in series with the Doherty combining circuit 005 respectively through an output impedance conversion circuit in the impedance conversion circuit 004. The Doherty combining circuit 005 may be a three-port microstrip network, the impedance value of each port of which may be decided by the powers of the main radio frequency power amplifier 001 and the peak radio frequency power amplifier 002.

During the study and practice process in the prior art, the inventor of the present application has found the following problems. Since the ADPA device has a high requirement on phases of two channels (i.e., the main radio frequency power amplifier 001 and the peak radio frequency power amplifier 002) and the radio frequency power amplifiers per se have a characteristics of discreteness, the discreteness between radio frequency power amplifiers with different batches will largely increase the phase difference between two channels, which causes a power combing loss of the ADPA device and has a serious impact on the performance of the ADPA device. However, such discreteness may be found only during application, resulting in that the performance of the ADPA device can not be controlled.

### SUMMARY

The embodiments of the present invention provides a power amplifier, an ADPA device and a base station, which can reduce the discreteness and improve the performance of power amplifier while guaranteeing high efficiency.

At one aspect, the present invention provides a power amplifier including at least two radio frequency power amplifier channels that are independent of each other and are different from each other, at least two input ports and at least two output ports; wherein each of the at least two radio frequency power amplifier channels that are independent of each other and are different from each other includes an input port for receiving an input signal, a radio frequency power amplifier unit for performing power amplification on a radio frequency signal, and an output port for outputting a signal; the input ports of the at least two radio frequency power amplifier channels that are independent of each other and are different from each other act as the input ports of the power amplifier, and the output ports of the at least two radio frequency power amplifier channels that are independent of each other and are different from each other act as the output ports of the power amplifier.

At another aspect, the present invention provides an asymmetric Doherty power amplifier (ADPA) device including an impedance conversion circuit and any one type of power amplifiers provided by the embodiments of the present invention; wherein the impedance conversion circuit includes an input impedance conversion circuit and/or an output impedance conversion circuit, and the input impedance conversion circuit and the output impedance conversion circuit are connected in series with the input port and output port of the power amplifiers respectively, to make the power amplifier match with other radio frequency circuits.

In the embodiments of the present invention, different radio frequency power amplifier channels are integrated within a component to form a power amplifier, thus reducing the discreteness between different radio frequency power amplifier channels in such a way that a test and a selection are performed before the component leaving factory, and avoiding the occurrence of a situation that the performance can not be controlled as the discreteness between the components can be only found during application in the prior art, which is helpful to improve the performance of the ADPA device.

### BRIEF DESCRIPTION OF DRAWINGS

To illustrate the technical solutions in the embodiments of the present invention or in the prior art more clearly, a brief introduction to the accompanying drawings which are needed in the description of the embodiments or the prior art is given below. Apparently, the accompanying drawings described below are merely some embodiments of the present invention, based on which other drawings can be obtained by the persons of ordinary skills in the art without any inventive efforts.
Fig.1 is a schematic diagram illustrating an ADPA circuit in the prior art.
Fig.2 is a schematic diagram illustrating a power amplifier provided in an embodiment of the present invention.
Fig.3 is a schematic diagram illustrating a power amplifier provided in another embodiment of the present invention.
Fig.4 is a schematic diagram illustrating an ADPA device provided in an embodiment of the present invention.
Fig.5 is a schematic diagram illustrating an ADPA device provided in another embodiment of the present invention.
Fig.6 is schematic structure diagram illustrating a radio frequency power amplifier unit provided in an embodiment of the present invention.

### DESCRIPTION OF EMBODIMENTS

The technical solutions according to the embodiments of the present invention will be described clearly and completely hereinafter with reference to the accompanying drawings in the embodiments of the present invention. Evidently, the described embodiments are merely part, but not all, of the embodiments of the present invention. All other embodiments, which can be derived by the persons of ordinary skills in the art based on the embodiments of the present invention without any inventive efforts, shall fall into the protection scope of the present invention.

The embodiments of the present invention provide a power amplifier, an asymmetric Doherty power amplifier device and a base station including the power amplifier or the asymmetric Doherty power amplifier device, which are described respectively in detail below.

A power amplifier includes at least two radio frequency power amplifier channels that are independent of each other and are different from each other, and includes at least two input ports and at least two output ports. Each of the radio frequency power amplifier channels includes an input port, a radio frequency power amplifier unit and an output port. The input port of each radio frequency power amplifier channel acts as the input port of the power amplifier, and the output port of each radio frequency power amplifier channel acts as the output port of the power amplifier. The radio frequency power amplifier unit is used for performing power amplification on a radio frequency signal.

In an embodiment of the present, a radio frequency power amplifier unit (Transistor) may include a flange (Flange), an active die (Die) and a bonding wire (Bonding Wire). The flange is a base of the radio frequency power amplifier channel. The active die is used for amplifying radio frequency signals. The bonding wire is used for making the active die connected with the input port or the output port of the radio frequency power amplifier channel. Furthermore, the radio frequency power amplifier unit may further include a circuit for providing pre-matching. In an embodiment of the present invention, the circuit for providing pre-matching may include a metal oxide semiconductor capacitor (MOS capacitor or CMOS) for connecting with the active die and the input port or output port of the radio frequency power amplifier channel through the bonding wire, and performing a pre-matching between the active die and the input port or the output port of the radio frequency power amplifier channel.

At least one of the power capacity, the size, the semiconductor material, the stage, the technics and the amount of the active dies of every two radio frequency power amplifier channels is different. The technics includes adopting a field effect transistor (FET, Field Effect Transistor) or a bipolar junction transistor (BJT, Bipolar Junction Transistor), etc.

For example, as shown in Fig.2, the power amplifier 100 may include a first radio frequency power amplifier unit 101 and a second radio frequency power amplifier unit 102, and include two input ports and two output ports. That is to say the power amplifier 100 includes two channels inside.

The first radio frequency power amplifier unit 101 and the second radio frequency power amplifier unit 102 are independent of each other. The input port of the first radio frequency power amplifier unit 101 and the input port of the second radio frequency power amplifier unit 102 act as the two input ports of the power amplifier 100. The output port of the first radio frequency power amplifier unit 101 and the output port of the second radio frequency power amplifier unit 102 act as the two output ports of the power amplifier 100.

The stage of the first radio frequency power amplifier unit 101 and that of the second radio frequency power amplifier unit 102 are the same, which are both one stage. But the first radio frequency power amplifier unit 101 and the second radio frequency power amplifier unit 102 are different in the power capacity, the size, the semiconductor material, the technics and the amount of the active Dies, etc. As shown in Fig.2, for the first radio frequency power amplifier unit 101, the power capacity is 50w, the size is smaller, the semiconductor material is Lateral Diffusion metal oxide semiconductor (LDMOS), the adopted technics is FET and the amount of active Dies is one. For the second radio frequency power amplifier unit 102, the power capacity is 150w, the size is larger, the semiconductor material is Gallium Nitride (GaN, Gallium Nitride), the adopted technics is BJT and the amount of active Dies is two.

For another example, as shown in Fig.3, the power amplifier 200 may include a first radio frequency power amplifier unit 201, a second radio frequency power amplifier unit 202 and a third radio frequency power amplifier unit 203, and include three input ports and three output ports. That is to say the power amplifier 200 includes three channels inside.

The first radio frequency power amplifier unit 201, the second radio frequency power amplifier unit 202 and the third radio frequency power amplifier unit 203 are independent of each other. The input port of the first radio frequency power amplifier unit 201, the input port of the second radio frequency power amplifier unit 202 and the input port of the third radio frequency power amplifier unit 203 act as the three input ports of the power amplifier 200. The output port of the first radio frequency power amplifier unit 201, the output port of the second radio frequency power amplifier unit 202 and the output port of the third radio frequency power amplifier unit 203 act as the three output ports of the power amplifier 200.

For the first radio frequency power amplifier unit 201, the second radio frequency power amplifier unit 202 and the third radio frequency power amplifier unit 203, their stages are the same, which are one stage, and the power capacity, the size, the semiconductor material and the amount of the active Dies, etc, are all different. While the technics adopted by the three radio frequency power amplifier unit is the same, which is FET. As shown in Fig.3, for the first radio frequency power amplifier unit 201, the power capacity is 50w, the size is smaller, the semiconductor material is LDMOS, and the amount of the active Dies is 1. The size of the second radio frequency power amplifier unit 202 and that of the third radio frequency power amplifier unit 203 are larger. For the second radio frequency power amplifier unit 202, the semiconductor material is GaN, the amount of the active die is 1, and the power capacity is 100w. For the third radio frequency power amplifier unit 203, the semiconductor material is Gallium Arsenide (GaAs, Gallium Arsenide), the amount of the active Dies is 2, and the power capacity is 150w.

It is to be noted that the above embodiments are described only by taking a power amplifier, which includes two or three channels inside, as an example. It should be understood that the power amplifier provided in an embodiment of the present invention may also include more than three channels inside, namely include more than three radio frequency power amplifier units. According to the needs of practice application, these radio frequency power amplifier units may adopt different active Dies, such as, different active Dies with different power capabilities, different sizes, different amounts, different stages, different semiconductor materials, or different technics, or the like.

Based on the above description, in the embodiments of the present invention, different radio frequency power amplifier units are integrated within one component to form a power amplifier, thus reducing the discreteness between different radio frequency power amplifier units in such a way that a test and a selection are performed during production and avoiding the occurrence of a situation that the performance can not be controlled as the discreteness between the components can be only found during application in the prior art. Since the power amplifier is a single component, a lower discreteness can be guaranteed during application, which is helpful to improve the efficiency of the component and the performance of the ADPA.

Furthermore, an effect which is only can be realized by multiple independent radio frequency power amplifiers in the prior art may be realized by adopting one power amplifier provided in an embodiment of the present invention. Since the power amplifier is a single component, it can be made into a component with very small size. Hence the area of a plate including one power amplifier provided in an embodiment of the present invention may be reduced availably and the cost may also be reduced, relative to adopting two independent radio frequency power amplifiers.

Accordingly, an embodiment of the present invention further provides an ADPA device, which includes an impedance conversion circuit, a Doherty combining circuit and any one type of power amplifier provided by the embodiments of the present invention.

The impedance conversion circuit is connected in series with an input port and/or an output port of the power amplifier, to match the power amplifier with other components (e.g., radio frequency component). The amount of impedance conversion circuits may be decided by the needs of practice application. For example, the impedance conversion circuit may include an input impedance conversion circuit and an output impedance conversion circuit, wherein the input impedance conversion circuit is connected with the input port of the power amplifier, and the output impedance conversion circuit is connected with the output port of the power amplifier.

The power amplifier is used for receiving an input signal, and after performing power amplification on the input signal, outputting the amplified signal to the impedance conversion circuit through the output port of the power amplifier.

The power amplifier may include at least two radio frequency power amplifier channels that are independent of each other and are different from each other. The at least two radio frequency power amplifier channels may include main radio frequency power amplifier channels and peak radio frequency power amplifier channels. For example, one channel of the radio frequency power amplifier channels is the main radio frequency power amplifier channel, and other channels are peak radio frequency power amplifier channels.

The Doherty combining circuit is used for making the output of each radio frequency power amplifier channel connect with each other. The specific configurations of the Doherty circuit may be not limited by the embodiments of the present invention. The Doherty combining circuit may be a multi-port microstrip network, the amount of ports of which may be decided by the amount of the radio frequency power amplifier channels included in the power amplifier. And an impedance value and a phase length of each port of the Doherty combining circuit may be decided by the power of each radio frequency power amplifier channel.

Furthermore, the ADPA device may further include a power divider.

The power divider is used for dividing an input signal into signals with different energies and transferring the signals to each of radio frequency power amplifier channels in the power amplifier respectively. Particularly, the power divider may be a hybrid coupler or a microstrip power divider, which is not limited by the embodiments of the present invention.

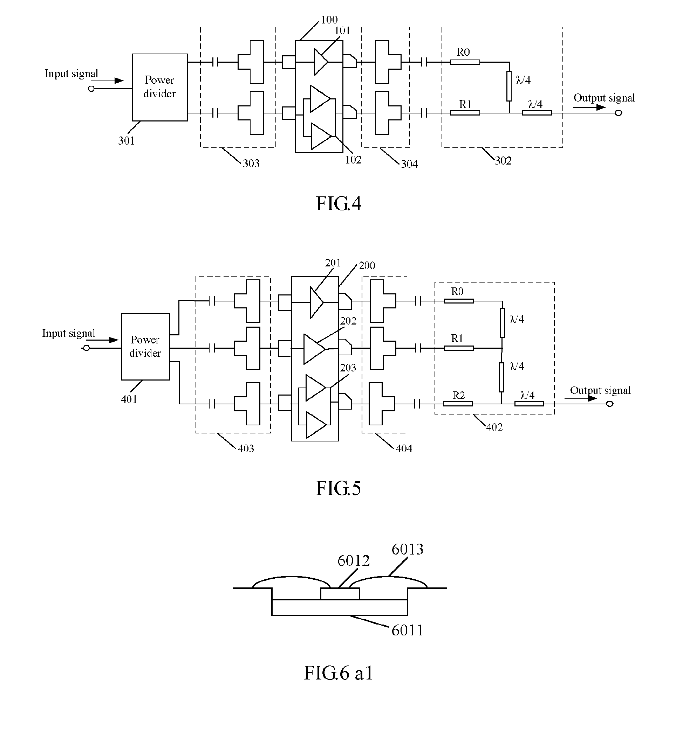

For example, as shown in Fig.4, the ADPA device includes a power divider 301, an input impedance conversion circuit 303, and a power amplifier 100, an output impedance conversion circuit 304 and a Doherty combining circuit 302.

The input signal enters the input impedance conversion circuit 303 through the power divider 301.

The power amplifier 100 may include a first radio frequency power amplifier unit 101 and a second radio frequency power amplifier unit 102, and include two input ports and two output ports. Namely, the power amplifier 100 includes two channels inside.

The first radio frequency power amplifier unit 101 and the second radio frequency power amplifier unit 102 are independent of each other. The input port of the first radio frequency power amplifier unit 101 and the input port of the second radio frequency power amplifier unit 102 act as the two input ports of the power amplifier 100, and are connected with the input impedance conversion circuit 303 respectively. The output port of the first radio frequency power amplifier unit 101 and the output port of the second radio frequency power amplifier unit 102 act as two output ports of the power amplifier 100, and are connected with the output impedance conversion circuit 304 respectively.

At least one of the power capacity, the size, the amount, the stage, the semiconductor material and the technics of the first radio frequency power amplifier unit 101 and the second radio frequency power amplifier unit 102 is different.

The first radio frequency power amplifier unit 101 is a main radio frequency power amplifier unit of the ADPA device, and the second radio frequency power amplifier unit 102 is a peak power amplifier unit of the ADPA device.

In an embodiment of the present invention, the power amplifier 100 may be an asymmetric component, which may meet the requirements of different power ratios. For example, if it is required that the power capacity ratio between the main radio frequency power amplifier unit and the peak radio frequency power amplifier unit is 1:2 and the total output power is 150w, the radio frequency power amplifier unit whose power is 50w may be selected as the main radio frequency power amplifier unit 101, and the radio frequency power amplifier unit whose power is 100w may be selected as the peak radio frequency power amplifier unit 012, etc.

For another example, as shown in Fig.5, the ADPA device includes a power divider 401, a power amplifier 200, an input impedance conversion circuit 403, an output impedance conversion circuit 404 and a Doherty combining circuit 402.

The power amplifier 200 may include three radio frequency power amplifier channels, namely, a first radio frequency power amplifier unit 201, a second radio frequency power amplifier unit 202 and a third radio frequency power amplifier unit 203, and also include three input ports and three output ports. Namely, the power amplifier 200 includes three channels inside.

The input signal enters the input impedance conversion circuit 403 through the power divider 401. After amplified by the three radio frequency power amplifier channels of the power amplifier 200, the input signal enters the output impedance conversion circuit 404, and then is outputted through the Doherty combining circuit 402.

The first radio frequency power amplifier unit 201, the second radio frequency power amplifier unit 202 and the third radio frequency power amplifier unit 203 are independent of each other. The input port of the first radio frequency power amplifier unit 201, the input port of the second radio frequency power amplifier unit 202 and the input port of the third radio frequency power amplifier unit 203 act as the three input ports of the power amplifier 200, and are connected with the input impedance conversion circuit 403 respectively. The output port of the first radio frequency power amplifier unit 201, the output port of the second radio frequency power amplifier unit 202 and the output port of the third radio frequency power amplifier unit 203 act as three output ports of the power amplifier 200, and are connected with the output impedance conversion circuit 404 respectively.

At least one of the power capacity, the size, the amount, the stage, the semiconductor material, and the technics of the first radio frequency power amplifier unit 201, the second radio frequency power amplifier unit 202 and the third radio frequency power amplifier unit 203 is different.

The first radio frequency power amplifier unit 201 may be a main radio frequency power amplifier unit of the ADPA device, and the second radio frequency power amplifier unit 202 and the third radio frequency power amplifier unit 203 may be peak radio frequency power amplifier units of the ADPA device.

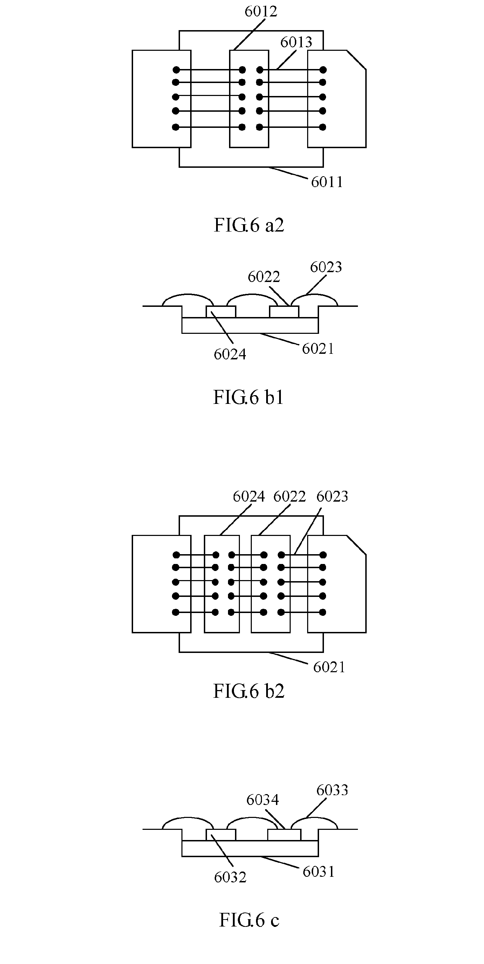

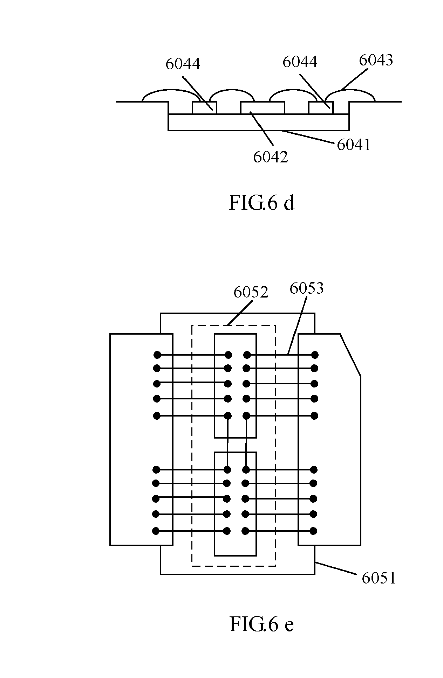

As shown in Fig.6, in an embodiment of the present invention, a radio frequency power amplifier unit (Transistor) may be composed of a flange 601, an active die 602 and a bonding wire 603, and may further include a pre-matching circuit. In an embodiment of the present invention, the pre-matching circuit may include a metal oxide semiconductor capacitor (MOS capacitor).

Fig.6a1 is a schematic side view illustrating a radio frequency power amplifier unit a composed of a flange 6011, an active die 6012 and a bonding wire 6013. Fig.6a2 is a schematic top view illustrating the radio frequency power amplifier unit a. The active die 6012 is connected with the input port and output port of the radio frequency power amplifier units through the bonding wire 6013 respectively.

Fig.6b1 is a schematic side view illustrating a radio frequency power amplifier unit b composed of a flange 6021, an active die 6022, a bonding wire 6023 and a metal oxide semiconductor capacitor 6024. Fig.6b2 is a schematic top view illustrating the radio frequency power amplifier unit b, wherein the bonding wire 6023 and the metal oxide semiconductor capacitor 6024 compose the pre-matching between the input ports of the radio frequency power amplifier units and the radio frequency power amplifier channels.

Fig.6c is a schematic side view illustrating a radio frequency power amplifier unit c composed of a flange 6031, an active die 6032, a bonding wire 6033 and a metal oxide semiconductor capacitor 6034, wherein the bonding wire 6033 and the metal oxide semiconductor capacitor 6034 compose the pre-matching between the output ports of the radio frequency power amplifier units and the radio frequency power amplifier channels.

Fig.6d is a schematic side view illustrating a radio frequency power amplifier unit d composed of a flange 6041, an active die 6042, a bonding wire 6043 and a metal oxide semiconductor capacitor 6044, wherein the bonding wire 6043 and the metal oxide semiconductor capacitor 6044 compose the pre-matching between the input ports/output ports of the radio frequency power amplifier units and the radio frequency power amplifier channels, respectively.

Fig.6e is a schematic top view illustrating a radio frequency power amplifier unit e composed of a flange 6051, an active die 6052 and a bonding wire 6053, wherein the amount of active dies 6052 is two.

It is to be noted that the above embodiments are described only based on a power amplifier, which includes two or three channels inside, as an example. It should be understood that the power amplifier provided by the embodiments of the present invention may include more than three channels inside, namely include more than three radio frequency power amplifier units. In addition, besides the connections as shown in Fig. 4 and Fig.5, the connection relationship among the power divider, the power amplifier and the impedance conversion circuit may be designed according to the requirements on practice application, which is not described repeatedly herein.

Based on above, the power amplifier of the ADPA device provided in the embodiments of the present invention is an asymmetric component, which may include multiple different radio frequency power amplifier channels inside. Thus it can reduce the discreteness between components and is helpful to improve the efficiency of the component and the performance of the entire ADPA device, while it can realize an effect that needs to be realized by multiple independent radio frequency power amplifiers in the prior art.

Furthermore, since the power amplifier is a single component, it may be made into a component with very small size. Accordingly the area of a plate including one power amplifier provided in an embodiment of the present invention may be reduced availably, relative to the situation that two independent radio frequency power amplifier are needed. As the radio frequency power amplifiers are packaged into one component, the consume of material may be reduced, which is helpful to reduce the cost, relative to the situation that the radio frequency power amplifiers are packaged respectively.

The embodiments of the present invention further provide a base station, which includes any one type of power amplifiers or any one type of ADPA devices included in the embodiments of the present invention.

A power amplifier, an asymmetric Doherty power amplifier device and a base station provided by the embodiments of the present invention have been described in detail above. The principle and embodiments of the present invention are described above with examples in the present text. The above embodiments are used to facilitate the understanding of the method and idea of the present invention. Moreover, those skilled in the art may further modify the embodiments and application scope according to the idea provided by the present invention, and hence the description above should not be taken as a limitation to the present invention.

## Claims

1. A power amplifier, **characterized in that**,
comprising at least two radio frequency power amplifier channels that are independent of each other and are different from each other, at least two input ports and at least two output ports;
wherein each of the at least two radio frequency power amplifier channels that are independent of each other and are different from each other comprises an input port for receiving an input signal, a radio frequency power amplifier unit for performing power amplification on a radio frequency signal, and an output port for outputting a signal;
the input ports of the at least two radio frequency power amplifier channels that are independent of each other and are different from each other act as the input ports of the power amplifier, and the output ports of the at least two radio frequency power amplifier channels that are independent of each other and are different from each other act as the output ports of the power amplifier.

2. The power amplifier according to claim 1, wherein the radio frequency power amplifier channels that are independent of each other and are different from each other comprise radio frequency power amplifier units that are different from each other, and the radio frequency power amplifier units that are different from each other mean that at least one of the power capacity, the size, the semiconductor material, the stage, the technics and the amount of the active dies of every two radio frequency power amplifier units is different.

3. The power amplifier according to claim 1 or 2, wherein the radio frequency power amplifier unit (Transistor) for performing power amplification on a radio frequency signal comprises an active die (Die), a bonding wire (Bonding Wire) and a flange (Flange).

4. The power amplifier according to any one of claims 1 to 3, wherein the radio frequency power amplifier unit (Transistor) for performing power amplification on a radio frequency signal further comprises a circuit for providing pre-matching, the circuit is used for providing a pre-matching between the active die and the input port or the output port of the radio frequency power amplifier channel, through the connection between the bonding wire and the active die, and the connection between the bonding wire and the input port or the output port of the radio frequency power amplifier channel.

5. The power amplifier according to claim 4, wherein the circuit for providing the pre-matching comprises a metal oxide semiconductor capacitor.

6. An asymmetric Doherty power amplifier (ADPA) device, **characterized in that**, comprising an impedance conversion circuit and a power amplifier according to any one of claims 1 to 5;
wherein the impedance conversion circuit comprises an input impedance conversion circuit and/or an output impedance conversion circuit, the input impedance conversion circuit and the output impedance conversion circuit are connected in series with the input port and the output port of the power amplifier respectively, to make the power amplifier match with other radio frequency circuits.

7. The asymmetric Doherty power amplifier device according to claim 6, further comprising a Doherty (Doherty) combining circuit for making the output of each radio frequency power amplifier channel comprised in the power amplifier connect with each other.

8. The asymmetric Doherty power amplifier device according to claim 7, wherein the Doherty combining circuit is a multi-port microstrip network, the amount of ports of the multi-port microstrip network is decided by the amount of radio frequency power amplifier channels comprised in the power amplifier, and the impedance value and the phase length of each port of the multi-port microstrip network is decided by the power of each radio frequency power amplifier channel.

9. The asymmetric Doherty power amplifier device according to any one of claims 6 to 8, further comprising a power divider for dividing an input signal into signals with different energies, and transferring the signals to each radio frequency power amplifier channel of the power amplifier respectively.

10. The asymmetric Doherty power amplifier device according claim 9, wherein the power divider is a hybrid coupler or a microstrip power divider.

11. A base station, **characterized in that**, comprising a power amplifier according to any one of claims 1 to 5, or comprising an asymmetric Doherty power amplifier device according to any one of claims 6 to 10.
